# DEMANDE DE BREVET EUROPEEN

(11) **EP 1 289 123 A1**
(43) Date de publication de la demande: **05.03.2003**
(21) Numéro de dépôt: 01203037.5
(22) Date de dépôt: 10.08.2001
(51) Int. Cl.: H03D 3/00

(54) **Dispositif à conversion de fréquence de signaux radiofréquences pour un récepteur GPS**

(71) Demandeur: ASULAB S.A., 2074 Marin (CH)
(72) Inventeur: Zellweger, Emil, 4514 Lommiswil (CH); Oesch, Yves, 2000 Neuchâtel (CH); Imfeld, Kilian, 2000 Neuchâtel (CH); Farine, Pierre-André, 2000 Neuchâtel (CH)
(74) Mandataire: Surmely, Gérard

(57) **Abrégé**

Le dispositif à conversion de fréquence (3) de signaux radiofréquences produit des signaux intermédiaires complexes (IF) pour un étage de corrélation d'un récepteur RF basse puissance. Pour ce faire, le dispositif comprend un premier filtre passe-bande sélectif (12) pour filtrer des signaux radiofréquences captés par une antenne (2). Un synthétiseur de fréquence (20 à 25) produit des premiers et seconds signaux haute fréquence, dont la fréquence des premiers signaux est supérieure à la fréquence des seconds signaux. Ce synthétiseur reçoit des signaux de référence d'un bloc oscillateur (26 à 29). Un premier bloc mélangeur (14) mélange les signaux radiofréquences avec les premiers signaux afin de produire des signaux convertis en fréquence. Un second filtre passe-bande (15) filtre les signaux du premier bloc mélangeur, et fournit des signaux à un second bloc mélangeur (16) pour les mélanger avec les seconds signaux haute fréquence. Finalement, des moyens de mise en forme (17,18,19) des signaux fournis par le second bloc mélangeur produisent les signaux intermédiaires. Le second filtre est un filtre actif peu sélectif qui est intégré dans un circuit intégré RF/IF (10) avec les premier et second blocs mélangeurs, les moyens de mise en forme des signaux, et certaines parties du synthétiseur et du bloc oscillateur.

## Description

L'invention concerne un dispositif à conversion de fréquence de signaux radiofréquences pour un récepteur RF basse puissance, notamment du type GPS. En fonction des signaux radiofréquences reçus, le dispositif produit des signaux intermédiaires destinés à être traités dans un étage de corrélation du récepteur RF basse puissance.

L'invention concerne également un circuit intégré RF/IF en tant que partie du dispositif à conversion de fréquence.

Le dispositif à conversion de fréquence comprend tout d'abord un premier filtre passe-bande pour filtrer des signaux radiofréquences captés par une antenne du récepteur, ledit premier filtre étant un filtre sélectif passif pour éliminer les fréquences images lors d'une première conversion de fréquence. Le dispositif comprend encore des moyens de génération de signaux oscillants pour produire des premiers et seconds signaux haute fréquence, la fréquence des premiers signaux étant supérieure à la fréquence des seconds signaux. Les premiers signaux haute fréquence sont mélangés aux signaux radiofréquences filtrés dans un premier bloc mélangeur. Les signaux produits par le premier bloc mélangeur ont une fréquence égale à la soustraction entre une fréquence porteuse des signaux radiofréquences et la fréquence des premiers signaux. Le dispositif comprend encore un second filtre passe-bande pour filtrer les signaux provenant du premier bloc mélangeur et un second bloc mélangeur pour mélanger les signaux filtrés par le second filtre avec les seconds signaux haute fréquence. Les signaux produits par le second bloc mélangeur ont une fréquence égale à la soustraction entre la fréquence des signaux provenant du premier bloc mélangeur et la fréquence des seconds signaux. Finalement, le dispositif comprend des moyens de mise en forme des signaux fournis par le second bloc mélangeur pour produire les signaux intermédiaires.

Dans le cas d'un récepteur GPS, l'étage de corrélation a pour tâche d'extraire les messages ou données GPS des signaux intermédiaires reçus du dispositif. Les messages sont transmis à des moyens à microprocesseur du récepteur pour le calcul de la position et de données temporelles. Bien entendu, il est nécessaire que le récepteur capte les signaux radiofréquences d'au moins quatre satellites visibles pour le calcul de la position.

Le dispositif à conversion de fréquence peut aussi être utilisé dans tout récepteur de signaux radiofréquences autre qu'un récepteur GPS. Il peut s'agir par exemple d'un récepteur utilisé dans un système de navigation par satellites de type GLONASS ou GALILEO. Il peut s'agir encore d'un récepteur utilisé dans un réseau de téléphonie mobile par exemple du type CDMA (Code-division multiple access en terminologie anglaise).

L'usage de récepteurs RF, notamment du type GPS, est actuellement bien répandu. Cela permet à un utilisateur d'un tel récepteur de pouvoir s'orienter en direction d'un but recherché et connaître la position du lieu qu'il occupe. De ce fait, cela devient nécessaire de pouvoir incorporer un récepteur RF dans des objets qui sont utilisés quotidiennement et qui peuvent être aisément transportables par une seule personne.

Les récepteurs GPS peuvent être montés par exemple dans une montre-bracelet ou dans un téléphone mobile. Cependant pour être montés dans ces objets de petite taille, les récepteurs doivent remplir certaines conditions. D'une part, la consommation des récepteurs basse puissance doit être fortement réduite, car les objets sont alimentés par des piles ou des accumulateurs de petite taille. D'autre part, le nombre de composants du récepteur doit également être considérablement réduit.

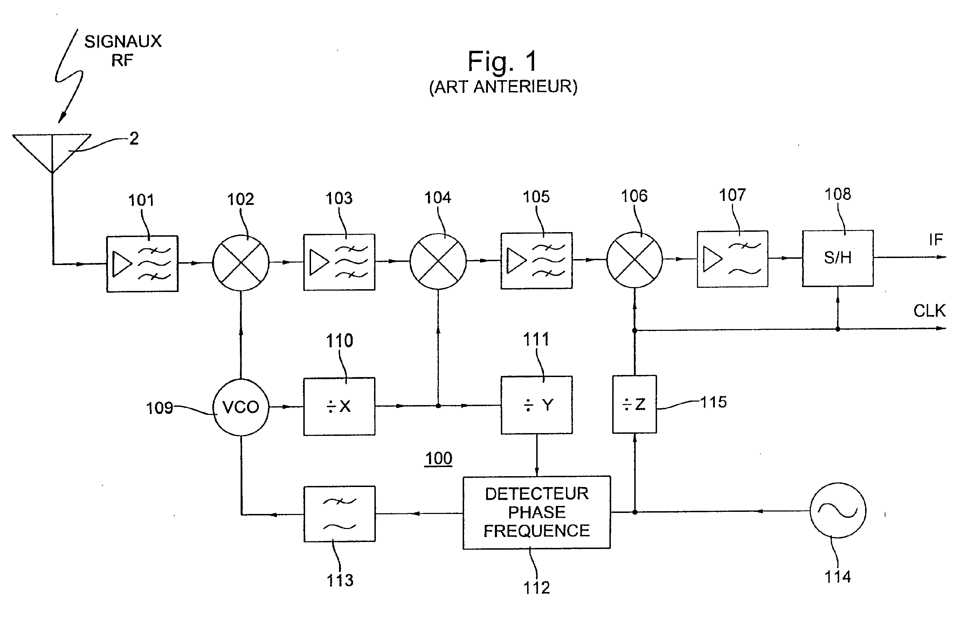

Habituellement, les dispositifs à conversion de fréquence de récepteurs RF sont conçus pour opérer une triple conversion de fréquence des signaux radiofréquences reçus. Une forme d'exécution d'un tel dispositif selon l'art antérieur est montré schématiquement à la figure 1.

En référence à cette figure 1, le dispositif à conversion de fréquence est relié à une antenne 2 du récepteur RF, notamment du type GPS, pour capter les signaux RF provenant de satellites visibles. Pour des applications civiles, la fréquence porteuse des signaux radiofréquences GPS vaut 1,57542 GHz.

Les signaux radiofréquences captés par l'antenne sont tout d'abord filtrés et amplifiés par un premier élément de filtrage et d'amplification 101. Les signaux radiofréquences filtrés par l'élément 101 sont ensuite mélangés dans un premier mélangeur 102 avec des premiers signaux haute fréquence fournis par un oscillateur commandé en tension 109. Les signaux ainsi produits par le mélangeur 102 sont des signaux dont la fréquence est égale à la soustraction entre la fréquence porteuse des signaux radiofréquences filtrés et la fréquence des premiers signaux haute fréquence.

Pour cette première opération de conversion de fréquence par le premier mélangeur 102, il est nécessaire que le filtre passe-bande de l'élément 101 soit un filtre passif sélectif notamment du type SAW. Ledit filtre de l'élément 101 doit être suffisamment sélectif pour éliminer la fréquence image des signaux radiofréquences à l'entrée du premier mélangeur.

Avec une fréquence des premiers signaux haute fréquence par exemple égale à 1,3961 GHz, la fréquence des signaux produits par le premier mélangeur vaut environ 179,3 MHz. Ainsi le premier filtre sélectif doit être en mesure d'éliminer la fréquence image valant 1,2168 GHz (1,3961 GHz - 0,1793 GHz) des signaux radiofréquences reçus.

Les signaux produits par le premier mélangeur 102 sont filtrés et amplifiés par un second élément de filtrage et d'amplification 103. Les signaux filtrés par l'élément 103 sont ensuite mélangés dans un second mélangeur 104 avec des seconds signaux haute fréquence fournis par un premier diviseur 110 connecté à l'oscillateur 109. Les signaux ainsi produits par le second mélangeur 104 sont des signaux dont la fréquence est égale à la soustraction entre la fréquence des signaux produits par le premier mélangeur et la fréquence des seconds signaux haute fréquence.

Pour cette deuxième opération de conversion de fréquence par le second mélangeur 104, il est nécessaire que le filtre passe-bande de l'élément 103 soit également un filtre passif sélectif notamment du type SAW.

Les premiers signaux haute fréquence sont divisés, par exemple, par 8 à l'aide du premier diviseur 110 pour produire les seconds signaux haute fréquence dont la fréquence vaut environ 174,5 MHz. Ainsi, la fréquence des signaux produits par le second mélangeur vaut environ 4,8 MHz. Le second filtre sélectif doit donc être en mesure d'éliminer la fréquence image valant environ 169,7 MHz (174,5 MHz - 4,8 MHz) des signaux produits par le premier mélangeur 102.

Les signaux produits par le second mélangeur 104 sont ensuite filtrés et amplifiés par un troisième élément de filtrage et d'amplification 105 qui comprend un filtre passe-bande. Les signaux filtrés par le troisième élément 105 sont mélangés dans un troisième mélangeur 106 avec des signaux d'horloge CLK fournis par un diviseur de fréquence 115 connecté à un oscillateur de référence 114.

La fréquence des signaux de référence produits par l'oscillateur de référence vaut par exemple 17,452 MHz. Cette fréquence de référence est divisée par 4 par le diviseur 115 pour produire des signaux d'horloge à la fréquence de 4,363 MHz. Ainsi pour cette troisième opération de conversion, la fréquence des signaux produits par le troisième mélangeur est proche de 400 kHz.

Les signaux produits par le troisième mélangeur 106 doivent encore être filtrés et amplifiés par un quatrième élément de filtrage et d'amplification 107, qui comprend un filtre passe-bas, et être échantillonnés et quantifiés par un convertisseur 108 (Sample and Hold en terminologie anglaise). Ce convertisseur 108 est cadencé par les signaux d'horloge CLK.

Pour produire les premiers et seconds signaux haute fréquence, le dispositif dispose d'un synthétiseur de fréquence à boucle de blocage de phase 100. Ce synthétiseur comprend l'oscillateur commandé en tension 109, deux diviseurs de fréquences 110 et 111, un détecteur de phase et de fréquence 112 pour comparer la fréquence des signaux provenant de l'oscillateur 109, qui sont divisés par les diviseurs 110 et 111, avec la fréquence des signaux de référence produits par l'oscillateur de référence 114. Les signaux de commande sortant du détecteur 112 sont filtrés par un filtre passe-bas 113 afin de produire une tension de commande à l'oscillateur 109 en fonction de la comparaison des signaux fournis audit détecteur 112.

Un inconvénient majeur du dispositif de la figure 1 est qu'il comprend un nombre trop important de composants électroniques pour réaliser la triple conversion de fréquence. Une grande partie des composants doit encore fonctionner à haute fréquence. De ce fait, la consommation en courant du dispositif est trop importante. Il n'est donc pas envisageable de monter un récepteur RF le comprenant dans un objet de taille réduite, car ledit objet comprend une pile ou un accumulateur de petite taille. Cette pile ou cet accumulateur se déchargerait trop rapidement lors du fonctionnement du récepteur RF.

Un autre inconvénient réside dans l'utilisation d'au moins deux filtres passe-bande sélectifs du type SAW qui sont des composants onéreux et encombrants. La dimension de chaque filtre encapsulé est de l'ordre de 5 mm x 5 mm x 1,3 mm, ce qui occasionne une perte importante de place pour un montage dans un objet de petite taille, tel qu'une montre-bracelet ou un téléphone cellulaire. Il est encore à noter que les filtres sélectifs du type SAW génèrent une perte de gain des signaux filtrés ce qui nécessitent d'amplifier lesdits signaux pour les opérations de traitement subséquentes.

Afin de diminuer le nombre de composants pour la conversion de fréquence dans un tel dispositif, il a déjà été proposé de n'opérer qu'une double conversion de fréquence au lieu de la triple conversion de fréquence habituelle. On peut citer à ce titre le brevet européen EP 0 523 938 B1 qui décrit un récepteur radio. Ledit récepteur comprend un dispositif à conversion de fréquence opérant une double conversion de fréquence des signaux radiofréquences reçus à une antenne.

Le dispositif à conversion de fréquence vu à la figure 1 de ce brevet comprend un synthétiseur de fréquence à boucle de blocage de phase 30 composé principalement d'un oscillateur commandé en tension 28 qui fournit des premiers signaux haute fréquence à un premier mélangeur 14. Le premier mélangeur reçoit encore des signaux radiofréquences filtrés et amplifiés par l'élément d'amplification et de filtrage 12 qui comprend un filtre passe-bande sélectif. Les signaux convertis produits par le premier mélangeur ont une fréquence de l'ordre de 200 MHz.

Un second élément d'amplification et de filtrage 16, qui comprend un filtre passe-bande sélectif, filtre et amplifie les signaux produits par le premier mélangeur 14 afin de fournir des signaux filtrés à un second mélangeur 18. Ce second mélangeur 18 reçoit également des seconds signaux haute fréquence dont la fréquence est un nombre entier de fois inférieur à la fréquence des premiers signaux haute fréquence. La fréquence des signaux produits par le second mélangeur est environ égale à 26 MHz. Ces signaux sont encore filtrés et amplifiés par un troisième élément 20 avant d'être fournis à un processeur 22.

Un inconvénient du dispositif présenté dans ce brevet européen réside dans le fait qu'il est nécessaire d'utiliser deux filtres passifs sélectifs qui peuvent être par exemple des filtres du type SAW. Même s'il est prévu d'intégrer les deux mélangeurs et une partie du synthétiseur de fréquence dans un même circuit intégré, les deux filtres sélectifs ne peuvent par contre pas être intégrés dans ledit circuit intégré. De ce fait, une perte de place importante subsiste avec l'emploi des filtres externes, et le coût de réalisation du dispositif avec ces composants onéreux reste élevé.

Un autre inconvénient réside dans le fait que la consommation en courant reste importante, car une grande partie des composants fonctionnent à haute fréquence et que les filtres sélectifs consomment énormément. Un montage d'un tel récepteur dans un objet de petite taille ne peut être facilement réalisé.

Un but de la présente invention consiste à réaliser un dispositif à conversion de fréquence réduisant au maximum la consommation en énergie ainsi que le nombre et la taille des composants électroniques pour opérer une double conversion de fréquence afin de pallier aux inconvénients des dispositifs de l'art antérieur. Ainsi, le récepteur RF comprenant ledit dispositif peut être aisément monté dans un objet de petite taille, tel qu'une montre-bracelet ou un téléphone cellulaire.

Ce but, ainsi que d'autres sont atteints par le dispositif à conversion de fréquence cité ci-devant qui se caractérise en ce que le second filtre est un filtre peu sélectif.

Dans un mode de réalisation préféré du dispositif, le second filtre est un filtre passe-bande actif dans lequel les signaux produits par le premier bloc mélangeur sont filtrés et amplifiés.

Dans un autre mode de réalisation préféré du dispositif, le second filtre est intégré dans un circuit intégré RF/IF avec les premier et second blocs mélangeurs, les moyens de mise en forme des signaux, et certaines parties des moyens de génération de signaux oscillants.

Un avantage de ce dispositif à conversion de fréquence réside dans le fait qu'un unique circuit intégré RF/IF peut comprendre les deux blocs mélangeurs, le second filtre passe-bande peu sélectif, les moyens de mise en forme des signaux fournis par le second bloc mélangeur pour produire les signaux intermédiaires, et la majeure partie des moyens de génération de signaux oscillants. Ces moyens de génération de signaux comprennent notamment au moins un synthétiseur de fréquence connecté à un bloc oscillateur lui fournissant des signaux de référence. Seuls un filtre passe-bas du synthétiseur et le cristal de quartz du bloc oscillateur sont des composants externes au circuit intégré RF/IF.

Le nombre et la taille des composants électroniques du dispositif à conversion de fréquence est ainsi réduit au minimum. En dehors du circuit intégré RF/IF, il ne reste que le premier filtre sélectif passif du type SAW avec un amplificateur des signaux radiofréquences captés par l'antenne du récepteur, ainsi que le filtre passe-bas et le cristal de quartz décrit ci-dessus.

Un autre avantage est que le second filtre passe-bande peut être intégré puisqu'il n'a plus besoin d'être sélectif. Ce second filtre est ainsi dénommé filtre peu sélectif. Ce second filtre est un filtre actif fournissant une amplification des signaux reçus, ce qui évite d'utiliser un amplificateur pour augmenter la sensibilité de détection des signaux radiofréquences. Il est à noter que ce second filtre n'a plus besoin d'être sélectif au même titre que le premier filtre passe-bande, car la fréquence des signaux produits par le premier mélangeur est dans une marge de 50 à 100 fois inférieure à la fréquence porteuse des signaux radiofréquences. Cette fréquence est par exemple de l'ordre de 26 MHz. Ainsi la fréquence image perturbatrice se trouve inclue dans la bande passante des signaux et n'a donc plus besoin d'être éliminée par un tel filtre sélectif.

La consommation en courant est grandement diminuée, car uniquement une double conversion de fréquence est opérée avec un second filtre peu sélectif peu gourmand en énergie. De plus, la majeure partie des composants fonctionnent à une fréquence inférieure au dispositif à conversion de fréquence de l'art antérieur.

Le but, ainsi que d'autres sont également atteints par le circuit intégré RF/IF pour un dispositif à conversion de fréquence caractérisé en ce qu'il comprend le premier bloc mélangeur, le second filtre passe-bande, le second bloc mélangeur, les moyens de mise en forme et la majeure partie des moyens de génération des signaux oscillants.

Pour les besoins de réduction de consommation et de taille des composants électroniques du dispositif, le circuit intégré RF/IF peut être réalisé en technologie CMOS à 0,25 µm ou inférieure. Toutefois, il serait envisageable également de le réaliser en technologie biCMOS ou bipolaire, voire avec une technologie CMOS supérieure à 0,25 µm.

Les buts, avantages et caractéristiques du dispositif à conversion de fréquence des signaux radiofréquences pour un récepteur RF apparaîtront mieux dans la description suivante d'au moins une forme d'exécution illustrée par les dessins sur lesquels :
- la figure 1 décrit ci-dessus représente un dispositif à conversion de fréquence des signaux radiofréquences selon l'art antérieur,
- la figure 2 représente schématiquement les diverses parties constituant un récepteur de signaux radiofréquences,
- la figure 3 représente un dispositif à conversion de fréquence de signaux radiofréquences selon l'invention,
- les figures 4a et 4b représentent des graphiques du gain des signaux filtrés par un second filtre passif externe en fonction de la fréquence des signaux filtrés, et
- la figure 5 représente un graphique du gain du second filtre intégré selon l'invention en fonction de la fréquence des signaux filtrés.

Dans la description suivante, les éléments du dispositif à conversion de fréquence pour un récepteur RF basse puissance qui sont bien connus de l'homme du métier dans ce domaine technique ne sont relatés que de manière simplifiée. De plus, il ne sera fait référence qu'à un dispositif pour un récepteur basse puissance de type GPS, même si le dispositif peut bien évidemment être utilisé dans tout autre type de récepteur RF.

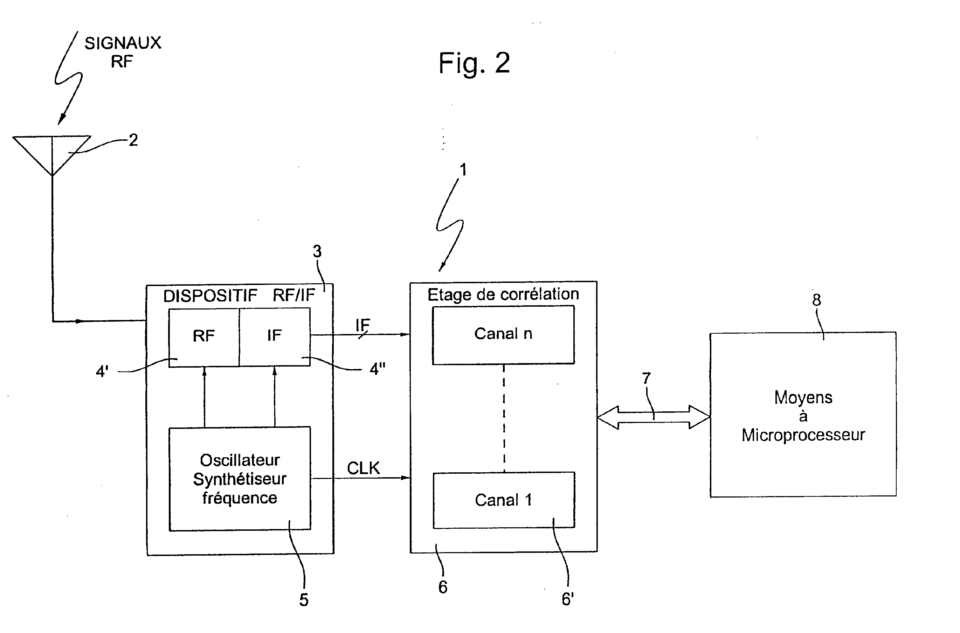

En référence à la figure 2, un récepteur de signaux radiofréquences 1 est schématiquement représenté. Ledit récepteur 1 comprend une antenne 2 pour recevoir les signaux RF provenant notamment de satellites visibles à chercher et à poursuivre. Dans le cas d'un récepteur GPS, il est nécessaire qu'au moins quatre satellites visibles soient poursuivis pour que le récepteur puisse extraire les données GPS pour le calcul de la position ou de la vitesse.

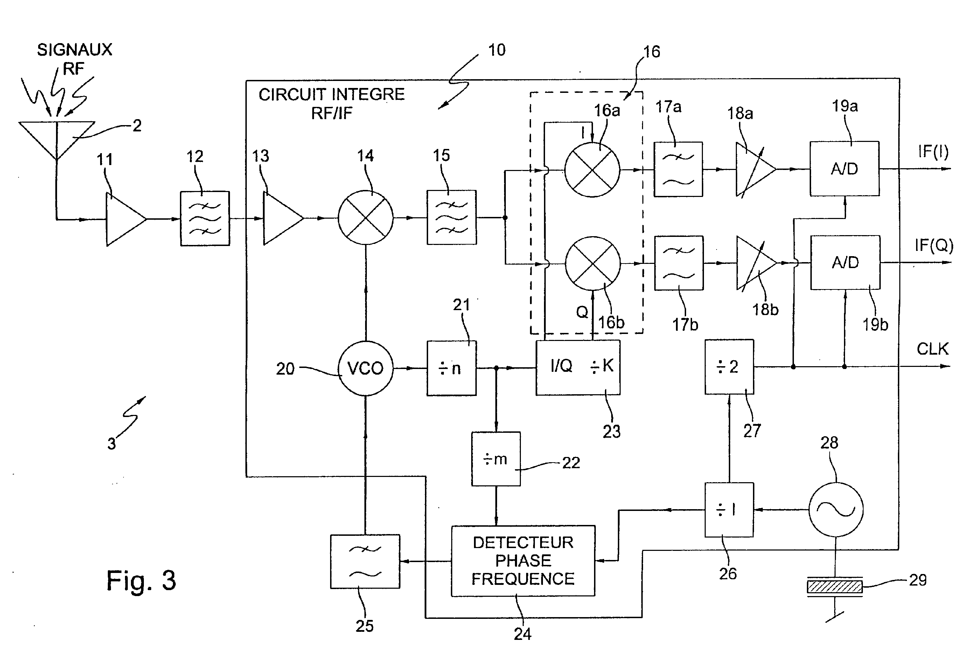

Le récepteur RF comprend un dispositif à conversion de fréquence 3, dénommé dispositif RF/IF sur la figure 2, relié directement à l'antenne 2 pour recevoir les signaux radiofréquences. Le dispositif à conversion de fréquence 3 a pour tâche d'abaisser la fréquence porteuse des signaux radiofréquences reçus par une double conversion de fréquence dans les circuits RF et IF 4' et 4". La conversion de fréquence dans les circuit 4' et 4" est réalisée grâce à des moyens de gestion de signaux oscillants 5. Ces moyens 5 comprennent notamment un bloc oscillateur de référence et un synthétiseur de fréquence. Les éléments constituant ledit dispositif objet de l'invention seront expliqués de manière plus détaillée ci-dessous en référence à la figure 3.

Le dispositif 3 fournit des signaux intermédiaires complexes IF échantillonnés et quantifiés à un étage de corrélation 6 qui est composé de plusieurs canaux de corrélation 6'. Les canaux 6' mis en fonction dans l'étage de corrélation vont extraire les données GPS grâce à des étapes de corrélation. Chaque canal 6' va générer une réplique du code pseudo-aléatoire spécifique du satellite à poursuive à corréler avec les signaux intermédiaires complexes IF. De plus, chaque canal génère également une réplique de la fréquence porteuse à corréler avec les signaux intermédiaires IF. Ainsi, dès que chaque canal s'est verrouillé sur le satellite poursuivi, il peut transmettre par un bus de données 7 les messages GPS à des moyens à microprocesseur 8. Ces moyens à microprocesseur 8 vont ainsi recevoir les données GPS d'au moins quatre canaux en fonction pour pouvoir calculer la position, la vitesse et les données temporelles.

Il est à noter que les signaux intermédiaires IF sont de préférence, sous forme complexe, composés d'une composante de signaux en phase I et d'une composante de signaux en quadrature Q à une fréquence de l'ordre de 400 kHz. Les signaux intermédiaires complexes IF sont représentés sur la figure 2 par une ligne coupée d'une barre oblique définissant 2 bits. Il est possible également que les signaux en phase et les signaux en quadrature soient chacun définis par 2 bits.

Le récepteur GPS basse puissance peut équiper un objet portable, tel qu'une montre-bracelet afin de fournir au besoin des données de position, de vitesse et de l'heure locale au porteur de la montre. Comme la montre possède un accumulateur ou une pile de petite taille, la puissance consommée doit être la plus faible possible lors du fonctionnement du récepteur GPS.

Bien entendu, le récepteur GPS pourrait équiper d'autres objets portables de petite taille à faible consommation, tels que des téléphones portables, qui sont munis également d'un accumulateur d'énergie ou d'une pile.

En référence à la figure 3, on va maintenant décrire une forme préférée de réalisation du dispositif à conversion de fréquence 3 objet de l'invention qui est relié à une antenne 2 de réception des signaux radiofréquences. Pour des applications civiles, la fréquence porteuse des signaux radiofréquences GPS vaut 1,57542 GHz.

Le dispositif 3 comprend tout d'abord un premier amplificateur 11 à faible bruit du type LNA (Low Noise Amplifier en terminologie anglaise), suivi d'un filtre passe-bande sélectif 12 SAW (Surface Acoustic Wave en terminologie anglaise). La sortie du filtre 12 est reliée à un circuit intégré RF/IF 10 destiné à opérer une double conversion de fréquence des signaux radiofréquences filtrés pour produire des signaux intermédiaires échantillonnés et quantifiés IF(I) et IF(Q).

Comme on peut le remarquer, le nombre de composants externes au circuit intégré RF/IF est réduit au minimum afin de permettre d'économiser suffisamment de place lors d'un montage dans une montre-bracelet ou dans un téléphone cellulaire. De plus, le circuit intégré 10 peut être réalisé dans un matériau semi-conducteur, tel que du Silicium, par une technologie CMOS à 0,25 µm par exemple. Ceci permet d'intégrer un nombre important de composants électroniques tout en garantissant également une diminution de la consommation électrique.

Le circuit intégré 10 RF/IF du dispositif à conversion de fréquence 3 reçoit donc des signaux radiofréquences filtrés et amplifiés. Un préamplificateur 13 à l'entrée du circuit RF/IF permet d'augmenter la sensibilité du circuit intégré pour traiter les signaux radiofréquences. Dans une première opération de conversion de fréquence, les signaux radiofréquences sortant du préamplificateur 13 sont mélangés dans un premier bloc mélangeur 14 avec des premiers signaux haute fréquence. Les premiers signaux haute fréquence sont fournis par un oscillateur commandé en tension 20 VCO faisant partie d'un synthétiseur de fréquence sur la base de signaux de référence fournis par un bloc oscillateur 26 et 28. Le bloc mélangeur 14 n'est constitué dans cette forme d'exécution que d'un unique mélangeur 14.

Les signaux ainsi produits par le mélangeur 14 sont des signaux dont la fréquence est égale à la soustraction entre la fréquence porteuse des signaux radiofréquences filtrés et la fréquence des premiers signaux haute fréquence. A titre d'exemple numérique non limitatif, la fréquence porteuse des signaux radiofréquences vaut 1,57542 GHz, alors que les premiers signaux haute fréquence sont fixés pour valoir 1,5508 GHz. La fréquence des signaux produits par le premier mélangeur 14 vaut donc 24,6 MHz qui est ainsi environ 64 fois inférieure à la fréquence porteuse des signaux radiofréquences. Toutefois, il est tout à fait envisageable d'avoir une fréquence des signaux située dans une marge de 50 à 100 fois inférieure à celle des signaux radiofréquences.

Pour cette première opération de conversion de fréquence par le premier mélangeur 14, il est nécessaire que le premier filtre passe-bande 12 soit un filtre passif sélectif notamment du type SAW. Ledit filtre 12 doit être suffisamment sélectif pour éliminer la fréquence image des signaux radiofréquences à l'entrée du premier mélangeur 14.

Avec une fréquence des premiers signaux haute fréquence par exemple égale à 1,5508 GHz, la fréquence des signaux produits par le premier mélangeur vaut environ 24,6 MHz. Ainsi le premier filtre sélectif doit être en mesure d'éliminer la fréquence image valant 1,5262 GHz (1,5508 GHz - 0,0246 GHz) des signaux radiofréquences reçus.

Les signaux produits par le premier mélangeur 14 sont filtrés et amplifiés par un second filtre passe-bande actif 15. Ce second filtre passe-bande n'a plus besoin d'être sélectif comme le premier filtre 11, car la fréquence image perturbatrice des signaux se trouvent inclue dans la bande passante des signaux GPS (24,6 MHz ± 1 MHz). Ce filtre 15 peut donc être avantageusement intégré dans le circuit intégré RF/IF. La seule restriction de ce filtre est qu'il doit être en mesure de supprimer la fréquence harmonique des 24,6 MHz qui se trouve donc proche des 49 MHz.

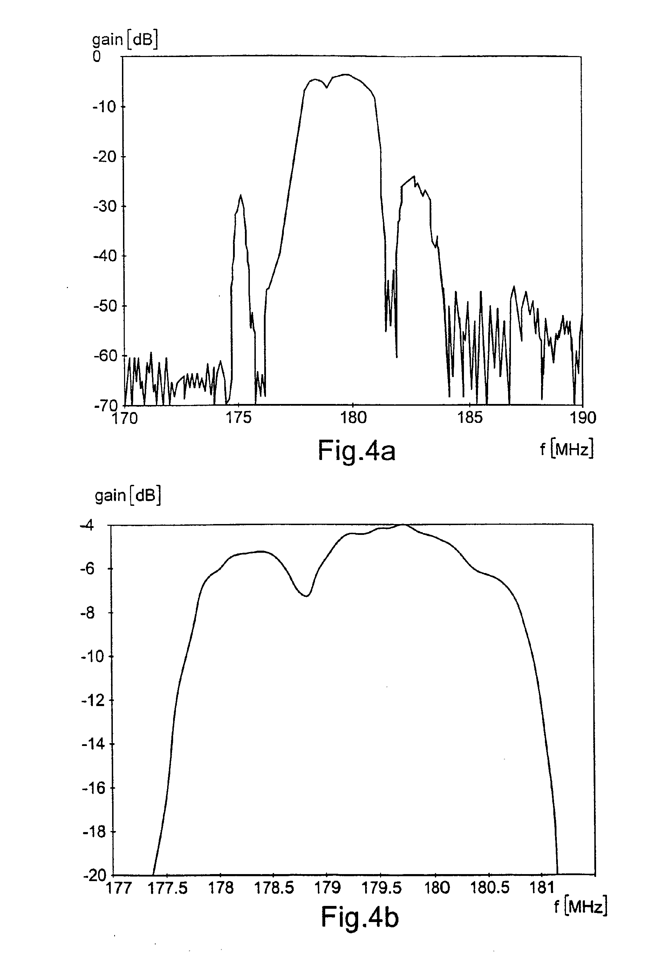

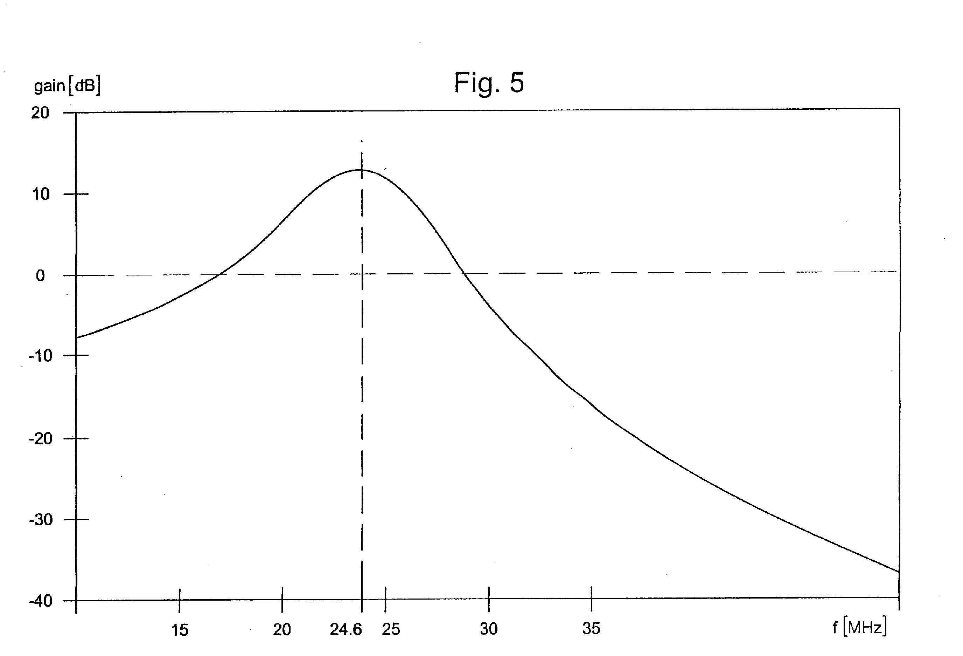

Le second filtre actif passe-bande peut être le filtre bien connu sous la dénomination IFA-gmC. Ce filtre a l'avantage d'amplifier les signaux produits par le premier mélangeur autour de la fréquence de 24,6 MHz, ce qui n'est pas le cas des filtres sélectifs passifs. A titre d'illustration, on peut se reporter aux figures 4 et 5 qui représentent des graphiques du gain en fonction de la fréquence des signaux pour chaque type de filtre.

Aux figures 4a et 4b, il est représenté la courbe de gain des signaux filtrés dans un filtre sélectif du type SAW autour de la fréquence de 179 MHz citée à titre d'exemple en référence à la figure 1. Dans ce cas, il était nécessaire que le filtre supprime la fréquence image 169,7 MHz à l'entrée d'un mélangeur devant produire des signaux à une fréquence de 4,8 MHz. On remarque qu'il y a une perte d'au moins 4 dB sur les signaux filtrés autour de 179 MHz, ce qui est un désavantage.

Il aurait été également possible de représenter la courbe de gain du premier filtre passe-bande du dispositif objet de l'invention. Ainsi, ce premier filtre sélectif doit être configurer pour supprimer la fréquence image 1,5262 MHz. Par la forme de la courbe de gain, on se rend bien compte de la complexité d'un tel filtre sélectif. Ce filtre est donc cher et encombrant, c'est pourquoi le dispositif à conversion de fréquence n'en comprend qu'un seul.

A la figure 5, il est représenté la courbe de gain des signaux filtrés par le second filtre actif passe-bande intégré dans le circuit intégré RF/IF autour de la fréquence de 24,6 MHz. Comme on peut le remarquer sur la figure 5, le filtre n'est pas sélectif car la pente d'atténuation autour de la fréquence de 24,6 MHz n'est pas raide. Ce filtre doit être en mesure de supprimer les signaux à la fréquence harmonique de 49 MHz.

En référence à nouveau à la figure 3, le second filtre 15 est suivi par un second bloc mélangeur 16 pour la deuxième conversion de fréquence. Ce bloc mélangeur 16 est constitué de deux mélangeurs 16a et 16b. Dans le mélangeur 16a, des seconds signaux haute fréquence en phase I sont mélangés avec les signaux filtrés par le second filtre 15. Dans le mélangeur 16b, des seconds signaux haute fréquence en quadrature Q sont mélangés avec les signaux filtrés par le second filtre 15.

Les seconds signaux haute fréquence en phase et en quadrature sont fournis par un élément registre diviseur 23 du synthétiseur de fréquence. Ce registre 23 reçoit des signaux d'un premier diviseur 21 connecté à l'oscillateur commandé en tension 20. A titre d'exemple numérique non limitatif, le premier diviseur 21 opère une division de fréquence par 32, alors que le registre diviseur 23 opère une division par 2. Si la fréquence des premiers signaux haute fréquence vaut 1,5508 GHz, cela donne une fréquence de 24,2 MHz des seconds signaux haute fréquence en phase et en quadrature.

Les signaux produits par les mélangeurs 16a et 16b sont des signaux dont la fréquence est égale à la soustraction entre la fréquence des signaux produits par le premier mélangeur et la fréquence des seconds signaux haute fréquence. Les signaux produits par chacun des mélangeurs 16a et 16b ont une fréquence voisine de 400 kHz.

Des moyens de mise en forme des signaux sont placés en sortie des mélangeurs 16a et 16b. Ces moyens comprennent à la suite de chaque mélangeur un filtre passe-bas (1,5 MHz) 17a et 17b, un amplificateur à gain commandé 18a et 18b et finalement un convertisseur analogique/digital 19a et 19b. Ainsi des signaux intermédiaires complexes échantillonnés et quantifiés IF(I) et IF(Q) sont produits par le dispositif à conversion de fréquence 3.

Chaque amplificateur 18a et 18b peut être commandé, afin d'ajuster l'amplification des signaux, par un détecteur de niveau intégré dans le circuit RF/IF ou par un corrélateur de l'étage de corrélation qui reçoit les signaux intermédiaires complexes.

Chaque convertisseur 19a et 19b sont cadencés par des signaux d'horloge CLK fournis par le bloc oscillateur. Le bloc oscillateur de référence comprend donc un oscillateur 28 à cristal de quartz 29 fournissant des signaux de référence à travers un diviseur d'oscillateur 26. La fréquence des signaux fournis par l'oscillateur est fixée par exemple à 16,154 MHz. Le diviseur d'oscillateur 26 divise les signaux par 2 par exemple, ce qui donne des signaux de référence à la fréquence de 8,08 MHz. Pour obtenir les signaux d'horloge à 4,04 MHz, la fréquence des signaux de référence sont divisés par 2 dans un diviseur 27. Ces signaux d'horloge CLK sont également fournis à l'étage de corrélation connecté au dispositif à conversion de fréquence, ainsi qu'aux moyens à microprocesseur. Toutefois, lesdits moyens à microprocesseur peuvent être cadencés également par les signaux de référence du bloc oscillateur de référence.

Le dispositif à conversion de fréquence comprend un synthétiseur de fréquence à boucle de blocage de phase décrit partiellement ci-dessus pour produire les premiers et seconds signaux haute fréquence. Ce synthétiseur comprend l'oscillateur commandé en tension 20, deux diviseurs de fréquences 21 et 22, un détecteur de phase et de fréquence 24 et un filtre passe-bas 25. Le détecteur de phase et de fréquence compare la fréquence des signaux provenant de l'oscillateur 20, qui sont divisés par les diviseurs 21 et 22, avec la fréquence des signaux de référence produits par le bloc oscillateur de référence. Les signaux de commande sortant du détecteur 24 sont filtrés par un filtre passe-bas 25 externe au circuit intégré RF/IF afin de produire une tension de commande à l'oscillateur 20 en fonction de la comparaison des signaux fournis audit détecteur 24.

La puissance consommée avec la configuration du dispositif décrit ci-dessus est bien inférieure à 30 mW, proche de 20 mW. L'intégration du second filtre dans le circuit intégré RF/IF, ainsi que la double conversion de fréquence garantit à un récepteur RF comprenant le dispositif de pouvoir être monté aisément dans un objet portable à pile ou accumulateur de petite taille.

A partir de la description qui vient d'être faite de multiples variantes de réalisation du dispositif à conversion de fréquence pour un récepteur basse puissance, notamment du type GPS, peuvent être conçues sans sortir du cadre de l'invention définie par les revendications.

## Revendications

1. Dispositif à conversion de fréquence (3) de signaux radiofréquences pour produire des signaux intermédiaires (IF) destinés à être traités dans un étage de corrélation (6) d'un récepteur RF basse puissance (1), le dispositif comprenant :
- un premier filtre passe-bande (12) pour filtrer des signaux radiofréquences captés par une antenne (2) du récepteur, ledit premier filtre étant un filtre sélectif passif pour éliminer les fréquences images lors d'une première conversion de fréquence,
- des moyens de génération de signaux oscillants (20 à 29) pour produire des premiers et seconds signaux haute fréquence, la fréquence des premiers signaux étant supérieure à la fréquence des seconds signaux,
- un premier bloc mélangeur (14) pour mélanger les signaux radiofréquences filtrés avec les premiers signaux haute fréquence afin de produire des signaux dont la fréquence est égale à la soustraction entre une fréquence porteuse des signaux radiofréquences et la fréquence des premiers signaux,
- un second filtre passe-bande (15) pour filtrer les signaux provenant du premier bloc mélangeur,
- un second bloc mélangeur (16) pour mélanger les signaux filtrés par le second filtre avec les seconds signaux haute fréquence afin de produire des signaux dont la fréquence est égale à la soustraction entre la fréquence des signaux provenant du premier bloc mélangeur et la fréquence des seconds signaux, et
- des moyens de mise en forme (17, 18, 19) des signaux fournis par le second bloc mélangeur pour produire les signaux intermédiaires,
ledit dispositif étant **caractérisé en ce que** le second filtre est un filtre peu sélectif.

2. Dispositif selon la revendication 1, **caractérisé en ce que** le second filtre est intégré dans un circuit intégré RF/IF (10) avec les premier et second blocs mélangeurs, les moyens de mise en forme des signaux, et certaines parties des moyens de génération de signaux oscillants.

3. Dispositif selon la revendication 1, **caractérisé en ce que** le second filtre est un filtre actif dans lequel les signaux produits par le premier bloc mélangeur sont filtrés et amplifiés.

4. Dispositif selon la revendication 1 pour un récepteur GPS basse puissance, **caractérisé en ce que** la fréquence des signaux produits par le premier bloc mélangeur est dans une marge de 50 à 100 fois, de préférence 64 fois, inférieure à une fréquence porteuse des signaux radiofréquences.

5. Dispositif selon l'une des revendications 1 et 4, **caractérisé en ce que** la fréquence des premiers signaux haute fréquence est n fois supérieure à la fréquence des seconds signaux haute fréquence, n étant un nombre entier choisi notamment dans la gamme de 50 à 100, de préférence égal à 64.

6. Dispositif selon l'une des revendications 1 et 2, **caractérisé en ce que** les moyens de génération de signaux oscillants comprennent un bloc oscillateur de référence et un synthétiseur de fréquence (20 à 25) connecté au bloc oscillateur de référence (26 à 29), ledit synthétiseur fournissant les premiers et deuxièmes signaux haute fréquence sur la base de signaux de référence fournis par le bloc oscillateur de référence.

7. Dispositif selon l'une des revendications 1 et 2, **caractérisé en ce que** les moyens de génération de signaux oscillants comprennent un bloc oscillateur de référence et un synthétiseur de fréquence (20 à 25) connecté au bloc oscillateur de référence (26 à 29), ledit synthétiseur fournissant les premiers signaux haute fréquence sur la base de signaux de référence fournis par le bloc oscillateur de référence et le bloc oscillateur fournissant les seconds signaux haute fréquence.

8. Dispositif selon l'une des revendications 6 et 7, **caractérisé en ce que** tous les éléments du synthétiseur de fréquence, qui comprend une boucle à blocage de phase, sont intégrés dans le circuit intégré RF/IF à l'exception d'un filtre passe-bas de filtrage de signaux de commande pour un oscillateur commandé en tension, l'oscillateur étant destiné à produire les premiers signaux haute fréquence.

9. Dispositif selon l'une des revendications 1, 6 à 8, **caractérisé en ce que** les seconds signaux haute fréquence sont composés de seconds signaux en phase et de seconds signaux en quadrature, et en ce le second bloc mélangeur comprend un premier mélangeur (16a) pour mélanger les signaux provenant du premier bloc mélangeur avec les seconds signaux en phase et un second mélangeur (16b) pour mélanger les signaux provenant du premier bloc mélangeur avec les seconds signaux en quadrature, les moyens de mise en forme recevant les signaux des premier et second mélangeurs (16a, 16b) pour fournir des signaux intermédiaires complexes composés de signaux en phase et de signaux en quadrature.

10. Dispositif selon la revendication 9, **caractérisé en ce que** les moyens de mise en forme comprennent, à la suite de chaque mélangeur du second bloc mélangeur, un filtre passe-bas (17a, 17b) suivi d'un amplificateur à gain commandé (18a, 18b) et d'un convertisseur analogique/digital (19a, 19b) cadencé par des signaux d'horloge (CLK) fournis par le bloc oscillateur, un des convertisseurs fournissant les signaux en phase des signaux intermédiaires échantillonnés et quantifiés, et l'autre convertisseur fournissant les signaux en quadrature des signaux intermédiaires échantillonnés et quantifiés.

11. Dispositif selon l'une des revendications 6 et 7, **caractérisé en ce que** le bloc oscillateur fournit des signaux de référence dont la fréquence est déterminée par un cristal de quartz (29), ladite fréquence étant de préférence située entre 10 et 20 MHz, et **en ce que** tous les éléments du bloc oscillateur sont intégrés dans le circuit intégré RF/IF à l'exception du cristal de quartz (29).

12. Circuit intégré RF/IF pour un dispositif selon l'une des revendications précédentes, **caractérisé en ce qu'**il comprend le premier bloc mélangeur, le second filtre passe-bande, le second bloc mélangeur, les moyens de mise en forme et la majeure partie des moyens de génération des signaux oscillants.

13. Circuit intégré RF/IF selon la revendication 12, **caractérisé en ce qu'**il est réalisé dans un matériau semi-conducteur, par exemple en Silicium, et dans une technologie CMOS à 0,25 µm ou inférieure.
